# EUROPÄISCHE PATENTSCHRIFT

(11) **EP 3 083 108 B1**
(45) Veröffentlichungstag und Bekanntmachung des Hinweises auf die Patenterteilung: **22.06.2022**
(21) Anmeldenummer: 14841417.0
(22) Anmeldetag: 17.12.2014
(51) Int. Cl.: B22F 1/00, C23C 14/14, B22F 9/22, C22C 19/05, C22C 27/06, C23C 24/04, C23C 4/11

(54) **VERFAHREN ZUR HERSTELLUNG EINER CHROM ENTHALTENDER SCHICHT**
METHOD OF MAKING A CHROMIUM CONTAINING COATING
PROCÉDÉ DE PRÉPARATION D'UN REVÊTEMENT CONTENANT DU CHROME

(30) Priorität: 20.12.2013 AT 4582013 U
(43) Veröffentlichungstag der Anmeldung: 26.10.2016
(73) Patentinhaber: Plansee SE, 6600 Reutte (AT)
(72) Erfinder: KATHREIN, Martin, A-6600 Reutte (AT); O'SULLIVAN, Michael, A-6600 Ehenbichl (AT)
(74) Vertreter: Ciesla, Bettina
(86) Internationale Anmeldenummer: PCT/AT2014/000226
(87) Internationale Veröffentlichungsnummer: WO 2015/089534

(56) Entgegenhaltungen:
- WO-A1-01/72455
- WO-A1-2012/026898
- WO-A2-2008/057710
- WO-A2-2015/027256
- DE-A1- 2 807 034
- DE-A1-102009 033 620
- DE-A1-102009 037 893
- DE-B3-102008 056 720
- DE-C2- 2 807 034
- JP-A- H04 165 058
- US-A1- 2013 220 523
- US-B1- 6 627 814

## Beschreibung

Die Erfindung betrifft ein Verfahren zur Herstellung einer Schicht unter Verwendung eines Beschichtungsstoffs, der Cr-enthaltende Partikel mit einem Cr-Gehalt > 95 Ma% umfasst, und eine Schicht. Beschichtungsstoffe üblicherweise in Pulver oder Granulatform werden vorzugsweise für thermische Spritzverfahren eingesetzt. Unter thermischen Spritzverfahren sind beispielsweise Plasmaspritzen (an Atmosphäre, unter Schutzgas oder unter niedrigem Druck), Pulverflammspritzen, Hochgeschwindigkeitsflammspritzen (HVOF, abgeleitet von High-Velocity-Oxygen-Fuel), Detonationsspritzen (Flammschockspritzen), Laserspritzen und Kaltgasspritzen (CGS, abgeleitet von Cold Gas Spraying) umfasst. Ein gemeinsames Merkmal aller thermischen Spritzprozesse ist das Zusammenspiel von thermischer und kinetischer Energie. Der Beschichtungsstoff wird in einem Spritzbrenner erhitzt (thermische Energie) und/oder auf hohe Geschwindigkeiten beschleunigt (kinetische Energie). So wird beispielsweise beim Kaltgasspritzen ein auf hohen Druck gebrachtes und erwärmtes Prozessgas (meist N₂, He oder Mischungen daraus) mittels einer Konvergent-Divergent Düse (auch als Überschalldüse bezeichnet) entspannt. Eine typische Düsenform stellt dabei die Lavaldüse (oder auch De Laval Düse genannt) dar. Dadurch wird die für den Spritzprozess benötigte kinetische Energie erzeugt. Je nach verwendetem Prozessgas sind Gasgeschwindigkeiten von 900 m/s (bei Stickstoff) bis 2500 m/s (bei Helium) erreichbar. Der Beschichtungsstoff wird beispielsweise vor dem engsten Querschnitt der Düse in den Gasstrom eingebracht und typischerweise auf 400 bis 1200 m/s beschleunigt. Es lassen sich durch Kaltgasspritzen mit vielen Werkstoffen dichte Schichten mit sehr guten Hafteigenschaften herstellen. Die Gastemperatur ist im Vergleich zu anderen Spritzverfahren sehr gering. Folglich ist auch die thermische Energie der Spritzpartikel stark reduziert, was Reaktionen mit Gasen vermindert. Damit haben jedoch die Eigenschaften des Beschichtungsstoffs einen signifikanten Einfluss auf den Beschichtungsprozess und somit auf die Qualität der abgeschiedenen Schicht.

Der Schichtaufbau bei thermisch gespritzten Schichten erfolgt lagenweise aus den einzelnen Partikeln des Beschichtungsstoffs. Es kommt zu einer lateralen Ausbreitung der erwärmten Partikel beim Aufprall auf der Substratoberfläche. Die auftreffenden Partikel bilden eine geschlossene Schicht, die in Abhängigkeit von den Eigenschaften des Beschichtungsstoffs von Poren und Mikrorissen durchzogen sein kann.

Für die Qualität einer thermisch gespritzten Schicht sind die Adhäsion des Beschichtungsstoffs zum Substratwerkstoff und die Kohäsion zwischen den Partikeln des Beschichtungsstoffs entscheidend. Grundsätzlich ist die Haftung thermisch gespritzter Schichten ein Zusammenspiel mehrerer physikalischer und chemischer Haftmechanismen, die abhängig sind von der Partikelgeschwindigkeit (kinetische Energie), der Partikeltemperatur (thermische Energie) und den Substrateigenschaften wie beispielsweise der Werkstoffzusammensetzung, der Rauheit und der Oberflächentemperatur. Beim Kaltgasspritzen kommt als weiteres Kriterium hinzu, dass die Partikel mit vergleichsweiser geringer Temperatur aus der Spritzdüse austreten. Bei Beschichtungsstoffen mit hoher Streckgrenze / Dehngrenze kann dies mit einer nicht ausreichenden Fließfähigkeit verbunden sein, wodurch kein Schichtaufbau möglich ist. Die zuvor geschilderten Anforderungen an eine Schicht, wie Schichthaftung, geringe Porosität, hohe Korngrenzenfestigkeit und Schichtduktilität werden von unterschiedlichen Beschichtungsstoffen in unterschiedlichem Maß erfüllt. Ein besonders schwierig zu verarbeitender Beschichtungsstoff ist dabei Chrom.

Die großtechnische Herstellung von Chrommetallpulver aus Chromoxiden erfolgt derzeit nur durch aluminothermische und elektrolytische Verfahren. So hergestellte Pulver weisen jedoch ein schlechtes Spritzverhalten, insbesondere bei einem niedrigen thermischen Energieanteil auf. Zudem sind aufgrund des Einsatzes von Cr(VI)-Verbindungen elektrolytische Verfahren umweltbedenklich. Zunehmend strengere Umweltauflagen führen dazu, dass dieser Prozess wirtschaftlich und umwelttechnisch kaum mehr vertretbar ist.

Neben den aluminothermischen und elektrolytischen Verfahren wurde auch versucht, Chromoxid mit Wasserstoff oder Kohlenstoff zu reduzieren, wie dies aus der Veröffentlichung "Metallurgy of the Rarer Metals - Chromium"; Arthur Henry Sully; Butterworths Scientific Publications (1954) und den Patenten bzw. Patentanmeldungen GB 512,502, JP 54013408 A, JP 07216474 A, JP 3934686 B2 sowie JP 06081052 A hervorgeht. Es hat sich jedoch herausgestellt, dass sich die beschriebenen Verfahren für eine großtechnische Umsetzung nicht eignen.

So war es mit den bekannten Cr-Pulvern bis dato nicht möglich, dichte, gut haftende, kaltgasgespritzte Schichten herzustellen. Zwar geht eine kaltgasgespritzte Schicht aus Cr, in einer Aufzählung mit W, Mo, Ti, Zr, Ni, Co, Fe, AI, Ag, Cu oder Legierungen daraus, mit einem O-Gehalt < 500 ppm und einem H-Gehalt < 500 ppm aus der WO 2008/057710 (A2) hervor, jedoch konnte eine technische Umsetzung nur mit den duktileren Werkstoffen, wie beispielsweise Ti, Zr, Ni, Co, Fe, Al, Ag und Cu erzielt werden. Zum Zeitpunkt der Anmeldung der Erfindung besteht die allgemeine Expertenmeinung, dass auf Grund der hohen Streckgrenze, der hohen Kaltverfestigung und der Sprödigkeit von Cr kaltgasgespritzte Cr-Schichten nicht herstellbar sind.

Dies ist mit ein Grund, dass nach wie vor der größte Anteil von Cr-haltigen Schichten galvanisch abgeschieden wird. Durch den schlechten Wirkungsgrad und die hohen Ströme entsteht beim Verchromen Wasserstoff und Sauerstoff. Durch platzende Bläschen wird das Chrombad fein zerstäubt. Wegen der hohen Krebsgefahr, die von Chrom-(VI) ausgeht, müssen die Chrombäder deshalb abgesaugt und das Entstehen der Chromaerosole unterdrückt werden. Aus diesem Grund besteht daher großes Interesse, von der umwelttechnisch problematischen Cr-Galvanik weg zu kommen. Zudem enthält eine Hartchromschicht ein dichtes Netzwerk sehr feiner Risse, die in etwa senkrecht zur Oberfläche verlaufen. Die Entstehung dieser Risse hängt eng mit dem bei der Abscheidung ausgasenden Wasserstoff zusammen. Ein Teil des Wasserstoffs wird vorübergehend in Form von Chromhydrid in der Chromschicht eingelagert. Beim anschließenden Zerfall des Chromhydrids kommt es zu einer Schrumpfung der Chromschicht und die daraus resultierenden Zugspannungen führen zu Rissen, was wiederum die Korrosionsschutzeigenschaften mindert.

Es ist daher die Aufgabe der Erfindung einen Cr-haltigen Beschichtungsstoff bereitzustellen, mit dem sich prozesssicher durch Kaltgasspritzen Cr-haltige Schichten, insbesondere mit einem hohen Cr-Gehalt, mit guter Schichthaftung und hoher Dichte herstellen lassen. Eine weitere Aufgabe der Erfindung ist die Bereitstellung eines Verfahrens zur Herstellung einer gut haftenden Cr-haltigen Schicht mit hoher Dichte, die möglichst frei von in etwa senkrecht zur Oberfläche verlaufenden Rissen ist. Eine weitere Aufgabe stellt die Bereitstellung einer hoch Cr-haltigen Schicht dar, die durch Kaltgasspritzen hergestellt ist.

Die Aufgabe wird durch die unabhängigen Ansprüche gelöst. Besondere Ausgestaltungsformen sind in den abhängigen Ansprüchen ausgeführt.

Der Beschichtungsstoff liegt bevorzugt in Pulver oder Granulatform vor. Unter Pulver versteht man dabei eine Vielzahl von Partikeln, wobei ein Partikel wiederum aus Primär- und damit verbundenen Sekundärpartikeln bestehen kann. Ist die Partikelgröße klein, kann es für den Spritzprozess vorteilhaft sein, eine Vielzahl von Pulverpartikeln, die wiederum aus Primär- und Sekundärpartikeln bestehen können, in ein Pulvergranulat überzuführen. Ein Pulvergranulat-Partikel kann daher aus einer Vielzahl von Partikeln bestehen. Diese Partikel können stoffschlüssig ohne oder mit Vorhandensein eines oder mehrerer weiterer Bestandteile miteinander verbunden sein. Die Größe der Pulverpartikel bzw. Pulvergranulat-Partikel wird als Partikelgröße bezeichnet und wird üblicherweise mittels Laserdiffraktometrie gemessen. Die Messergebnisse werden als Verteilungskurve angegeben. Der d₅₀ Wert gibt dabei die mittlere Partikelgröße an. d₅₀ bedeutet, dass 50 % der Partikel kleiner sind als der angegebene Wert.

Der Beschichtungsstoff umfasst Cr-reiche Bereiche mit einem Cr-Gehalt > 95 Ma% (Masseprozent). Die Cr-reichen Bereiche bestehen zumindest teilweise aus einer Cr-reichen Phase. Cr-reicher Bereich und Cr-reiche Phase werden im Folgenden synonym verwendet. Eine Cr-reiche Phase mit einem Cr-Gehalt > 95 Ma% bedeutet, dass der Anteil an gelösten Elementen ≤ 5 Ma% ist. Bevorzugt liegt der Großteil (> 70 Ma%, insbesondere > 80 Ma%, im Besonderen > 90 Ma%) des im Beschichtungsstoff enthaltenen Cr in Form von Cr-reicher Phase mit einem Cr-Gehalt > 95 Ma% vor. In der Cr-reichen Phase können andere Phasenbestandteile eingelagert sein. Diese werden bei der Auswertung des Cr-Gehalts in der Cr-reichen Phase nicht berücksichtigt. Liegt der Gehalt an gelösten Elementen > 5 Ma% (Cr-Gehalt < 95 Ma%) weisen diese Bereiche eine zu hohe Härte auf, was sich negativ auf das Spritzverhalten auswirkt. Die Cr-reichen Bereiche bilden Partikel (in weiterer Folge auch Cr-enthaltende Partikel oder nur Partikel genannt).

Erfindungswesentlich ist nun, dass die Cr-enthaltenden Partikel weisen eine mittels BET gemessene mittlere Oberfläche > 0,05 m²/g auf.

Die Cr-enthaltenden Partikel liegen vorteilhaft zumindest teilweise als Aggregate oder Agglomerate vor. Unter Aggregat wird dabei in der Pulvermetallurgie ein Cluster von Primärpartikeln verstanden, die über eine starke Bindung miteinander verbunden sind, während bei einem Agglomerat ein Cluster von Primärpartikeln über eine schwache Bindung miteinander verbunden sind (siehe Beispielsweise German, R.: "Introduction to Powder Metallurgy Science", MPIF, Princeton (1984) 32). Als Aggregat wird im Folgenden ein Cluster bezeichnet, das sich nicht durch übliche Ultraschall-Deagglomeration aufbrechen lässt, während Agglomerate zumindest teilweise in die Primärpartikel zerlegbar sind. Die Ultraschall-Deagglomeration wird dabei mit 20 kHz und 600 W durchgeführt. In vorteilhafter Weise liegt dabei der Beschichtungsstoff als Aggregat vor, wie dies auch aus den Beispielen hervorgeht. Die Bindung zwischen den Cr-haltigen Primärteilchen ist dabei stoffschlüssig (metallurgical bonding), bevorzugt ohne Mitwirken von anderen Elementen. In besonders vorteilhafter Weise liegen > 20 %, insbesondere > 50 % aller Partikel als Aggregat oder Agglomerat vor. Die Auswertung erfolgt dabei folgendermaßen. Es werden 5 Proben gezogen, die mittels Rasterelektronenmikroskop untersucht werden.

Bei einer Vergrößerung, die im Bildausschnitt 20 bis 50 Partikel umfasst, lässt sich in einfacher Weise zuordnen, ob der Partikel als Aggregat / Agglomerat vorliegt oder nicht. Es wird die Anzahl der als Aggregat / Agglomerat vorliegenden Partikel ermittelt, auf die Gesamtzahl der ausgewerteten Partikel bezogen und der Mittelwert aus den fünf Proben ermittelt.

Im Weiteren ist es vorteilhaft, wenn die Cr-enthaltenden Partikel eine mittlere Nanohärte H_{IT} 0,005/5/1/5 von ≤ 4 GPa aufweisen. Die Nanohärte H_{IT} 0,005/5/1/5 wird dabei nach EN ISO 14577-1 (Ausgabe 2002) mit einem Berkovich-Eindringkörper und dem Auswerteverfahren nach Oliver und Pharr bestimmt. Der Härtewert bezieht sich dabei auf ein Pulver oder Pulvergranulat, das vorzugsweise keiner zusätzlichen Nachbehandlung, wie beispielsweise einer Glühung, unterzogen wird. Bevorzugt beträgt die Nanohärte ≤ 3,5 GPa. Bei sehr hohen Anforderungen ist eine Nanohärte H_{IT} 0,005/5/1/5 von ≤ 3 GPa vorteilhaft. Bei sehr reiner Cr-Phase lassen sich Metallpulver mit einer Nanohärte H_{IT} 0,005/5/1/5 von in etwa 1,5 GPa realisieren. Zur Ermittlung der Nanohärte wird ein Pulverschliff angefertigt und die Nanohärte auf der polierten Querschnittsfläche der Partikel ermittelt.

Die Cr-enthaltenden Partikel weisen zumindest teilweise Poren auf. In besonders vorteilhafter Weise weisen > 20%, insbesondere > 50 % aller Partikel Poren auf. Die Auswertung erfolgt dabei durch eine rasterelektronenmikroskopische Untersuchung wie zuvor für das Merkmal Aggregat / Agglomerat beschrieben.

Im Weiteren weisen die Partikel eine mittlere, mittels quantitativer Bildanalyse bestimmte Porosität > 10 Vol% auf. Besonders bevorzugt beträgt die mittlere Porosität der Partikel > 20 Vol%, insbesondere bevorzugt > 40 Vol%. Es konnten Werte von 85 Vol% und darüber erreicht werden. Bevorzugte Bereiche für die Porosität P sind 10 Vol% < P < 85 Vol%, 20 Vol% < P < 85 Vol% oder 40 Vol% < P < 85 Vol%. Die Bestimmung der mittleren Porosität folgt dabei folgender Arbeitsanweisung. Es werden zunächst Pulverschliffe angefertigt.

Das Pulver wird hierzu in Epoxidharz eingebettet. Nach einer Aushärtezeit von 8 Stunden werden die Proben metallographisch präpariert, d.h. es kann später eine Untersuchung über den Pulverquerschliff hinweg erfolgen. Die Präparation umfasst die Schritte: Schleifen bei 150 bis 240 N mit festgebundenem SiC - Papier mit den Körnungen 800, 1000 und 1200; Polieren mit Diamant-Suspensionen mit 3 µm Körnung; finales Polieren mit einer OPS (Oxid-Polier-Suspension) der Körnung 0,04 µm; Reinigung der Proben im Ultraschallbad und Trocknung der Proben. Anschließend werden je Probe zehn Bilder von unterschiedlichen, repräsentativen Partikeln angefertigt. Dies geschieht mittels Rasterelektronenmikroskopie unter Verwendung eines 4-Quadranten-Ring-Detektors zur Detektion rückgestreuter Elektronen (BSE: back-scattered-electrons). Die Anregungsspannung beträgt 20 kV, der Kippwinkel 0°. Die Aufnahmen werden scharf gestellt. Die Auflösung soll zumindest 1024x768 Pixel für eine korrekte Bildanalyse betragen. Der Kontrast wird derart gewählt, dass sich die Poren deutlich von der metallischen Matrix abheben. Die Vergrößerung für die Aufnahmen wird derart gewählt, dass jedes Bild ein Partikel enthält. Die quantitative Bildanalyse wird mit der Software Image Access durchgeführt. Es wird das Modul "Partikel Analyse" genutzt. Jede Bildanalyse folgt den Schritten: Einstellung eines Graustufenschwellwertes in der Art, dass offenes Porenvolumen in den Körnern erkannt wird; Festlegung des Messrahmens, in diesem Fall ein maximal großer Kreis / Rechteck innerhalb eines Kornes (Fläche 0,02 - 0,5 mm²); Detektionseinstellung: Messung nur in ROI, Einschließen des Bildrands, Abschneiden des ROI durch Objekt. Es werden weder bei der Aufnahme noch bei der Analyse der Aufnahmen Filterfunktionen verwendet. Da die Poren in einem Rückstreuelektronenbild dunkler erscheinen als die metallische Matrix werden bei der Detektionseinstellung die "dunklen Objekte" als Poren definiert. Nachdem die 10 Bilder einzeln analysiert worden sind, erfolgt eine statistische Auswertung über die Daten hinweg. Daraus wird der mittlere Flächenanteil der Poren (%) bestimmt, der der mittleren Porosität in Volumenprozent gleichgesetzt werden kann.

Bei den erfindungsgemäßen Poren handelt es sich bevorzugt um zumindest teilweise offene Poren. Unter offenen Poren sind dabei Poren zu verstehen, die über Porenkanäle mit der Oberfläche verbunden sind. In günstiger Weise ist der Volumenanteil von offenen Poren bezogen zur Gesamtporosität > 30 Vol%, in sehr günstiger Weise > 50 Vol%, bevorzugt > 70 Vol% und besonders bevorzugt > 90 Vol%. Diese offenen Poren sind wiederum bevorzugt miteinander vernetzt. Die vorteilhafte, bevorzugt offene Porosität und/oder die Pulverform (Aggregate oder Agglomerate) tragen auch zu einer sehr hohen spezifischen BET Oberfläche der Cr-enthaltenden Partikel, von > 0,05 m²/g bei. Die BET-Messung erfolgt dabei gemäß Norm (ISO 9277:1995, Messbereich: 0,01 - 300 m²/g; Gerät: Gemini II 2370, Ausheiztemperatur: 130°C, Ausheizzeit: 2 Stunden; Adsorptiv: Stickstoff, volumetrische Auswertung über Fünfpunktbestimmung). Weitere bevorzugte Ausführungsformen sind: BET Oberfläche ≥ 0,06 m²/g, ≥ 0,07 m²/g, ≥ 0,08 m²/g, ≥ 0,09 m²/g oder ≥ 0,1 m²/g.

Sowohl die Pulverform (Aggregat oder Agglomerat), die geringe Nanohärte, die hohe BET Oberfläche und die Porosität wirken sich einzeln oder insbesondere vorteilhaft in Kombination günstig auf das Spritzverhalten aus. Es ist davon auszugehen, dass die geringe Nanohärte das Fließvermögen der einzelnen Pulverpartikel günstig beeinflusst. Die Wirkmechanismen der Porosität, der Pulverform und der BET Oberfläche auf das Spritzverhalten sind noch nicht im Detail verstanden. Es ist durchaus möglich, dass dies ein Zusammenspiel mehrerer Effekte ist, nämlich:
- Reduzierung der Fließspannung
- Begünstigung mikroplastischer Fließvorgänge
- Geringere Verfestigung über Kaltverformung (geringere Versetzungswege zur nächstliegenden Oberfläche, auch Porenoberfläche)
- Höhere Partikel-Breitung beim Aufprall
- Bessere mechanisches Verzahnen und damit höhere Haftfestigkeit.

Wie ein Beschichtungsstoff mit den zuvor beschriebenen Merkmalen in prozesssicherer Weise hergestellt werden kann, wird noch im Detail beschrieben.

Im Weiteren ist es vorteilhaft, wenn die Cr-enthaltenden Partikel eine Partikelgröße d₅₀ von > 5 µm und < 150 µm aufweisen. Der d₅₀ Wert wird dabei mittels Laserdiffraktometrie unter Anwendung der Norm (ISO13320 - 2009) gemessen. Weitere vorteilhafte Bereiche sind: 10 µm < d₅₀ < 120 µm oder 15 µm < d₅₀ < 100 µm. Werte im unteren Größenbereich können dabei ohne einen zusätzlichen Granulierschritt erzielt werden. Erfolgt die Herstellung ohne Granulierung wird das hergestellte Produkt als Pulver bezeichnet. Werte im oberen d₅₀-Bereich können erzielt werden, wenn beispielsweise das Ausgangsprodukt (z.B. Cr-Oxid oder Cr-Hydroxid), ein Zwischenprodukt (z.B. Cr-Metallpulver) mit üblichen Verfahren granuliert wird. Ein derartig hergestelltes Produkt wird als Pulvergranulat bezeichnet.

Bei sehr spröden Werkstoffen wie beispielsweise Cr wurde bis dato die Partikelgröße des Beschichtungsstoffs sehr fein gehalten, weil nur die kleinen Partikel die für eine Haftung notwendige Geschwindigkeit erreichen. Sehr feine Pulver fließen jedoch sehr schlecht und können zu einer Verstopfung der Pulverfördersysteme führen. Zudem kommt es bei Verwendung von feinem Pulver zu einer Verschlechterung der Schichtqualität, da die Partikelbindung beim Aufprall auf dem Substrat bei Pulver mit sehr kleiner Partikelgröße schlechter als bei gröberem Pulver ist. Diese Größeneffekte beruhen auf dynamischen Effekten wie dem sehr schnellen Ausgleich der beim Aufprall lokal an den Grenzflächen gebildeten Wärme sowie auf einer höheren dynamischen Festigkeit des Werkstoffes durch Dehnratenverfestigung. Beides ist stärker ausgeprägt beim Aufprall kleiner Partikel. Mit dem erfindungsgemäßen Beschichtungsstoff ist es nun möglich, auch bei geringeren Aufprallgeschwindigkeiten eine hohe Schichtqualität zu erzielen. Damit können auch gröbere Pulver verwendet werden. Erfindungsgemäß beträgt der Cr-Gehalt im Beschichtungsstoff > 20 Ma%, bevorzugt > 50 Ma%, > 60 Ma%, > 70 Ma% oder > 80 Ma%, insbesondere bevorzugt > 90 Ma%, 95 Ma% oder > 99 Ma%.

Der Beschichtungsstoff führt auch zu vorteilhaften Ergebnissen, wenn ein oder mehrere weitere Beschichtungsstoffe zugegeben werden. Speziell beim Kaltgasspritzen konnten ausgezeichnete Resultate erzielt werden, wenn auf der Oberfläche der Cr-enthaltenden Partikel zumindest bereichsweise ein Material aufgebracht ist, das eine niedrigere Streckgrenze und/oder Härte als Cr aufweist. Der bevorzugte Gehalt beträgt dabei 0,01 bis 50 Ma%, insbesondere bevorzugt 0,1 bis 30 Ma% oder 3 bis 25 Ma%. Als besonders geeignet haben sich dabei flächenzentrierte Metalle wie beispielsweise Ni oder Cu gezeigt.

Die Schichthärte kann in vorteilhafter Weise durch die Zugabe eines Hartstoffs erhöht werden. Als Hartstoff können dabei alle üblichen Hartstoffe, wie beispielsweise Karbide, Boride oder Nitride eingesetzt werden. Vorteilhafte Karbide sind beispielhaft Chrom- oder Wolframkarbide. Die Chromkarbide können dabei in-situ bei der Herstellung erzeugt werden, was zu einer besonders homogen und feinen Verteilung der Karbide führt. In überraschender Weise lassen sich Pulvermischungen mit bis zu 80 Ma% Hartstoffanteil, Rest Cr noch durch Kaltgasspritzen verspritzen. Der bevorzugte Anteil von Hartstoff im Beschichtungsstoff beträgt 0,1 Ma% bis 80 Ma%, insbesondere bevorzugt 1 Ma% bis 50 Ma%.

Vorteilhafte Eigenschaften lassen sich jedoch auch erzielen, wenn dem Beschichtungsstoff ein Festschmierstoff, wie beispielsweise Graphit, ein Sulfid (vorteilhaft Molybdändisulfid), Bornitrid oder ein Oxid (vorteilhaft Vanadiumoxid) zugegeben wird. Der maximale Gehalt an Schmierstoff ist durch die erzielbare Schichtqualität bestimmt. Bevorzugt beträgt der Gehalt an Schmierstoff 0,1 Ma% bis 30 Ma%, insbesondere bevorzugt 1 Ma% bis 25 Ma%.

Es hat sich sogar gezeigt, dass der erfindungsgemäße Beschichtungsstoff auch dann zu einer Verbesserung der Schichteigenschaften führt, wenn dieser nur zur Herstellung einer Schicht Verwendung findet, deren Basis ein anderer Werkstoff ist. So kann beispielsweise eine Schicht aus einer MCrAIY Legierung in sehr hoher Qualität mittels Kaltgasspritzen hergestellt werden. Unter MCrAIY versteht man dabei eine Ni- oder Fe-Basis-Legierung, die Cr, Al und ein Seltenerdmetall (beispielsweise Y) umfasst.

In vorteilhafter Weise enthält der Beschichtungsstoff 0,005 bis 5 Ma% eines oder mehrerer Seltenerdmetalle (einschließlich Yttrium). Die Seltenerdmetalle können bevorzugt auch in oxidierter Form vorliegen. Seltenerdmetalle oder Seltenerdmetalloxide wirken sich insbesondere günstig auf die Korrosionseigenschaften aus.

Bevorzugte weitere Zusammensetzungen (bevorzugter Cr Gehalt > 50 Ma%) sind:
- Cr enthaltend zumindest ein Metall der Gruppe Fe, Co, Mn, Al Nb, Ta und V; bevorzugter Gehalt 0,01 bis 50 Ma%; insbesondere bevorzugter Gehalte 0,1 bis 30 Ma% oder 3 bis 25 Ma%;
- Cr enthaltend zumindest ein Metall der Gruppe Ti, Zr, Hf, Mo, W und Re; bevorzugter Gehalt 0,01 bis 20 Ma%;
- Cr enthaltend Si und/oder B, bevorzugt 0,005 bis zu 20 Ma%, insbesondere bevorzugt bis 10 Ma%, 5 Ma% oder 2 Ma%.

Alle in der Beschreibung genannten Legierungskomponenten erbringen auch in Kombination vorteilhafte Eigenschaften.

Die erfindungsgemäße Aufgabe wird durch ein Verfahren zur Herstellung einer Schicht unter Verwendung des Beschichtungsstoffs durch Kaltgasspritzen gelöst. In vorteilhafter Weise umfasst das Verfahren zumindest die folgenden Schritte:
- Bereitstellen eines Prozessgases mit einem Druck von 10 bis 100 bar, vorteilhaft 20 bis 60 bar, besonders vorteilhaft 30 bis 50 bar und einer Temperatur zwischen Raumtemperatur und 1400°C, vorteilhaft 300 bis 1200°C, besonders vorteilhaft 600 bis 1000°C;
- Beschleunigung des Prozessgases in einer Konvergent-Divergent Düse bevorzugt auf Überschallgeschwindigkeit;
- Injizieren des erfindungsgemäßen Beschichtungsstoffs vor, in oder nach der Konvergent-Divergent Düse in das Prozessgas; und
- Bildung einer haftenden Schicht beim Auftreffen des Beschichtungsstoffs auf einem Substrat.

Die oberen Bereiche der vorteilhaften Drücke und Temperaturen ergeben sich aus den derzeit verfügbaren Anlagen. Grundsätzlich steigern eine höhere Prozessgastemperatur und ein höherer Druck die Auftreffgeschwindigkeit der Partikel auf der Substratoberfläche und wirken sich daher günstig auf die Schichteigenschaften aus. Eine höhere Prozessgastemperatur bewirkt auch eine höhere Temperatur der Teilchen beim Auftreffen auf der Substratoberfläche, was sich ebenfalls günstig auf die Schichteigenschaften auswirkt. Sollten daher zukünftig Anlagen verfügbar sein, die höhere Drücke und/oder Temperaturen ermöglichen, können sich die vorteilhaften Bereiche zu höheren Werten hin verschieben.

Es ist bekannt, dass die Aufprallgeschwindigkeit der Partikel ein kritisches Limit überschreiten muss, um Haftung der Partikel auf dem Substrat zu erzielen. Diese kritische Geschwindigkeit hängt hauptsächlich vom verwendeten Beschichtungsstoff, der Partikelgröße und der Temperatur von Partikel und Substrat ab. Mit dem erfindungsgemäßen Beschichtungsstoff ist es möglich, die kritische Aufprallgeschwindigkeit deutlich zu erniedrigen. Damit ist es auch möglich, Stickstoff oder ein stickstoffreiches (> 50 Vol% Stickstoff) Gas als Prozessgas zu verwenden. Somit sind Prozessgase wie Helium oder Helium-haltige Gasmischungen, die zwar zu höheren Gasgeschwindigkeiten führen, dies jedoch bei deutlich höheren Prozesskosten, nicht erforderlich. In vorteilhafter Weise wird daher Stickstoff oder ein stickstoffreiches Gas als Prozessgas verwendet.

Es hat sich jedoch auch gezeigt, dass auch mit Verfahrenstechniken, bei denen die Partikelgeschwindigkeit im Vergleich zum Kaltgasspritzen geringer und die Partikeltemperatur höher sind, der erfindungsgemäße Beschichtungsstoff vorteilhaft einsetzbar ist. So konnten sehr gute Beschichtungsergebnisse mit Hochgeschwindigkeitsflammspritzverfahren erzielt werden.

Die erfindungsgemäße Aufgabe wird auch durch eine Schicht mit einem Cr-Gehalt > 50 Ma%, einer mittleren Dicke > 20 µm und einem Mikrogefüge, das zumindest teilweise verformte Cr-haltige Körner aufweist, gelöst. In bevorzugter Weise beträgt die mittlere Dicke > 30, > 40 oder > 50 µm. Bevorzugt beträgt der Cr-Gehalt > 70 Ma%, insbesondere bevorzugt > 90 Ma%, > 95 Ma% oder > 99 Ma%. Die verformten Cr-haltigen Körner der Schicht weisen bevorzugt eine mittlere Nanohärte H_{IT} 0,005/5/1/5 von > 4 GPa auf. Die mittlere Nanohärte H_{IT} 0,005/5/1/5 beträgt bevorzugt > 4,3 GPa, > 4,6 GPa, > 4,9 GPa, > 5,2 GPa, > 5,5 GPa oder > 6 GPa. Die Bestimmung der Schichtdicke erfolgt dabei durch übliche metallographische Verfahren. Die Messung der Nanohärte erfolgt an einem Querschliff in analoger Weise wie in der Beschreibung für die Bestimmung der Pulverhärte erläutert.

Die Schicht wird bevorzugt durch Kaltgasspritzen hergestellt. Vorteilhaft umfasst das Kaltgasspritzen zumindest die Schritte Bereitstellen eines Prozessgases mit einem Druck von 10 bis 100 bar und einer Temperatur zwischen Raumtemperatur und 1400°C; Beschleunigung des Prozessgases in einer Konvergent-Divergent Düse; Injizieren des Beschichtungsstoffs vor, in oder nach der Konvergent-Divergent Düse in das Prozessgas; und Bildung einer haftenden Schicht beim Auftreffen des Beschichtungsstoffs auf einem Substrat. In vorteilhafter Weise wird dabei Stickstoff oder ein Stickstoff reiches Gas als Prozessgas verwendet. Wie bereits eingehend ausgeführt, war es bis dato nicht möglich, Schichten aus einem Cr-Basis-Werkstoff (Cr-Gehalt > 50 Ma%) durch Kaltgasspritzen herzustellen. Kaltgasspritzen impliziert eine Verformung der Körner bei einer Temperatur < Schmelzpunkt der gespritzten Partikel. Bevorzugt sind dabei die Körner kaltverformt. Unter Kaltverformung ist dabei die metallkundliche Definition zu verstehen, nämlich dass die Partikel beim Auftreffen auf das Substrat bei einer Temperatur verformt werden, die unter der jeweiligen Rekristallisationstemperatur des Werkstoffs liegen. Da die Einwirkzeit der Temperatur sehr kurz, ist die für die Rekristallisation erforderliche Temperatur entsprechend der Arrhenius Gleichung sehr hoch. Die Verformung der Partikel beim Auftreffen führt dazu, dass die aus den Partikeln entstehenden Körner der Schicht bevorzugt in lateraler Richtung (parallel zur Schichtoberfläche) zumindest teilweise gestreckt sind, wobei das mittlere (Mittelwert aus zumindest 10 gestreckten Körnern) Streckungsverhältnis (aspect ratio) > 1,3 ist. Insbesondere bevorzugt beträgt das mittlere Streckungsverhältnis > 2, > 3, > 4 oder > 5. Das Streckungsverhältnis wird metallographisch, zum Beispiel durch Bildanalyse, bestimmt Bevorzugte Zusammensetzungen (auch in Kombination der aufgezählten Komponenten) der Schicht sind:
- Cr-Gehalt > 60 Ma%, > 70 Ma%, > 80 Ma% oder > 90 Ma%; insbesondere bevorzugt Cr mit Reinheit > 95 Ma% oder > 99 Ma%;
- Cr (Cr Gehalt > 50 Ma%) enthaltend ein Festschmierstoff, wie beispielsweise Graphit, ein Sulfid (vorteilhaft Molybdändisulfid), Bornitrid oder ein Oxid (vorteilhaft Vanadiumoxid), bevorzugter Gehalt an Schmierstoff 0,1 bis 30 Ma%, insbesondere bevorzugt 1 Ma% bis 25 Ma%;
- Cr (Cr Gehalt > 50 Ma%) enthaltend zumindest einen Hartstoff; insbesondere ein oder mehrere Karbide (beispielsweise Chrom- und Wolframkarbide), Boride und/oder Nitride; bevorzugter Hartstoffanteil > 0,1 Ma%, insbesondere bevorzugt > 1 Ma%; bevorzugter Bereich für Hartstoffanteil 0,1 bis 50 Ma%;
- Cr (Cr Gehalt > 50 Ma%) enthaltend zumindest ein weiteres Metall;
   - Bevorzugt zumindest ein Metall mit einer niedrigeren Streckgrenze und/oder Härte als Cr; bevorzugter Gehalt 0,01 bis 50 Ma%;
   - Bevorzugt zumindest ein Metall der Gruppe Ni, Cu, Fe, Co, Mn, Al Nb, Ta und V; bevorzugter Gehalt 0,01 bis 50 Ma%; insbesondere bevorzugter Gehalte 0,1 bis 30 Ma% oder 3 bis 25 Ma%;
   - Bevorzugt zumindest ein Metall der Gruppe Ti, Zr, Hf, Mo, W und Re; bevorzugter Gehalt 0,01 bis 20 Ma%;
   - Bevorzugt zumindest ein Seltenerdmetall (einschließlich Yttrium); bevorzugter Gehalt 0,005 bis 5 Ma%; bevorzugt auch in oxidierter Form vorliegend;
- Cr (Cr Gehalt > 50 Ma%) enthaltend Si und/oder B, bevorzugt 0,005 bis zu 20 Ma%, insbesondere bevorzugt bis 10 Ma%, 5 Ma% oder 2 Ma%.

Die erfindungsgemäße Schicht weist vorzugsweise eine Dichte (gemessen mit Auftriebsmethode) von > 85 %, insbesondere von > 93 %, 95 % oder 98 % auf. Der O-Gehalt (Sauerstoffgehalt) der Schicht beträgt vorzugsweise < 0,3 Ma%, < 0,2 Ma% oder < 0,1 Ma%. Der C-Gehalt (Kohlenstoffgehalt) der Schicht beträgt vorzugsweise < 0,05 Ma%, < 0,035 Ma% oder < 0,02 Ma%. Im Weiteren ist die Schicht vorzugsweise frei von Partikeln, die keine Formänderung durch den Spritzvorgang erfahren haben.

Im Folgenden wird ein Verfahren beschrieben, mit dem in einfacher und prozesssicherer Weise der erfindungsgemäße Beschichtungsstoff kostengünstig hergestellt werden kann.

Dieses Verfahren umfasst die Reduktion zumindest einer Verbindung der Gruppe bestehend aus Cr-Oxid und Cr-Hydroxid, optional mit einer beigemischten festen Kohlenstoffquelle, unter zumindest zeitweiser Einwirkung von Wasserstoff und Kohlenwasserstoff. Als Chromoxid oder Chromhydroxid kommen bevorzugt Cr(III)-Verbindungen in Pulverform in Frage, beispielsweise Cr₂O₃, CrOOH, Cr(OH)₃ oder Mischungen aus Chromoxiden und Chromhydroxiden. Die bevorzugte Chromquelle ist Cr₂O₃. Für einen hohen Reinheitsgrad im Endprodukt ist bevorzugt vorgesehen, dass das verwendete Cr₂O₃ zumindest Pigmentqualität besitzt.

Bevorzugt wird die Verbindung der Gruppe bestehend aus Cr-Oxid und Cr-Hydroxid, optional mit einer beigemischten festen Kohlenstoffquelle, auf eine Temperatur T_{R} mit 1100°C ≤ T_{R} ≤ 1550°C erhitzt und optional auf dieser Temperatur gehalten. Temperaturen < 1100°C bzw. > 1550°C führen zu verschlechterten Pulvereigenschaften, bzw. zu einem unwirtschaftlicheren Verfahren. Die Reaktion verläuft für industrielle Zwecke dann besonders gut ab, wenn Temperaturen T_{R} von etwa 1200 °C bis 1450°C gewählt werden.

Während im unteren erfinderischen Temperaturbereich sehr lange Haltezeiten auf T_{R} erforderlich sind, um einen vorteilhaften Reduktionsgrad von 90% einzustellen, kann im oberen erfinderischen Temperaturbereich die Haltezeit sehr kurz gewählt werden oder überhaupt entfallen. Der Reduktionsgrad R ist definiert als das Verhältnis der bis zum Zeitpunkt t abgebauten Stoffmenge an Sauerstoff, bezogen auf die insgesamt vorhandene Sauerstoffmenge im Chromoxid bzw. Chromhydroxid.

Basierend auf den Beispielen kann der Fachmann in einfacher Weise die für seinen Ofen (Durchlaufofen, Batchofen, maximal erreichbare Ofentemperatur,...) optimale Kombination aus Temperatur und Zeit bestimmen. Bevorzugt wird die Reaktion über zumindest 30%, insbesondere bevorzugt zumindest 50% der Reaktionszeit im Wesentlichen konstant (isotherm) auf T_{R} gehalten.

Die Anwesenheit von Kohlenwasserstoff gewährleistet, dass über einen chemischen Transportprozess Pulver mit den erfindungsgemäßen Eigenschaften gebildet wird. Der Gesamtdruck der Reaktion beträgt in vorteilhafter Weise 0,95 bis 2 bar. In vorteilhafter Weise liegt der Kohlenwasserstoff als CH₄ vor. Bevorzugt beträgt zumindest während des Aufheizvorgangs zumindest zeitweise der Kohlenwasserstoff-Partialdruck 5 bis 500 mbar. Die Restgasatmosphäre ist dabei bevorzugt Wasserstoff. Bevorzugt erfolgt die Einwirkung von Wasserstoff und Kohlenwasserstoff zumindest im Temperaturbereich 800°C bis 1050°C.

Bevorzugt beträgt in diesem Temperaturbereich der Kohlenwasserstoff-Partialdruck 5 bis 500 mbar. Die sich aus den Ausgangsstoffen bildende Reaktionsmischung befindet sich dabei bevorzugt zumindest 45 min., insbesondere bevorzugt zumindest 60 min. in diesem Temperaturbereich. Diese Zeit schließt sowohl den Aufheizvorgang als auch etwaige isotherme Haltephasen in diesem Temperaturbereich ein. Mit den erfinderischen Verfahrensbedingungen ist gewährleistet, dass sich bei Temperaturen bevorzugt < T_{R} zumindest eine Verbindung ausgewählt aus der Gruppe bestehend aus Cr-Oxid und Cr-Hydroxid unter Einwirkung von Wasserstoff und Kohlenwasserstoff zumindest teilweise zu Chromkarbid umsetzt. Bevorzugte Chromkarbide sind Cr₃C₂, Cr₇C₃ oder Cr₂₃C₆. Die sich über den Kohlenwasserstoff-Partialdruck einstellende teilweise Bildung von Chromkarbid wirkt sich wiederum günstig auf die Pulvereigenschaften aus. Mit den erfinderischen Verfahrensbedingungen ist weiters gewährleistet, dass sich das Chromkarbid mit dem in der Reaktionsmischung vorhandenen und/oder zugemischten Cr-Oxid / Cr-Hydroxid zu Cr umsetzt, wobei dieser Prozess bei T_{R} dominiert.

Der Kohlenwasserstoff kann der Reaktion gasförmig zugegeben werden. Bevorzugt wird dabei die zumindest eine Verbindung der Gruppe bestehend aus Cr-Oxid und Cr-Hydroxid unter zumindest zeitweiser Einwirkung eines H₂-CH₄ Gasgemisches reduziert. Vorteilhaft wird ein H₂/CH₄ Volumenverhältnis im Bereich 1 bis 200, besonders vorteilhaft von 1,5 bis 20 gewählt. Die Einwirkung des H₂-CH₄ Gasgemisches erfolgt dabei bevorzugt zumindest zeitweise während der Aufheizphase auf T_{R}, wobei der Einfluss auf die Ausbildung der Pulverform insbesondere im Temperaturbereich 850 bis 1000°C sehr günstig ist. Wird eine Temperatur von ca. 1200°C erreicht, wird bevorzugt auf eine Rein-Wasserstoffatmosphäre, bevorzugt mit einem Taupunkt von < -40°C (gemessen im Bereich der Gaszufuhr) umgeschaltet. Liegt T_{R} unter 1200°C erfolgt das Umschalten auf die Rein-Wasserstoffatmosphäre bevorzugt bei Erreichen von T_{R}. Die isotherme Phase auf T_{R} und Abkühlen auf Raumtemperatur erfolgen vorteilhaft in einer Wasserstoffatmosphäre. Insbesondere beim Abkühlen ist es vorteilhaft, Wasserstoff mit einem Taupunkt < -40°C zu verwenden, um Rückoxidation zu vermeiden.

Es kann dem Cr-Oxid und/oder Cr-Hydroxid auch eine feste Kohlenstoffquelle zugemischt werden. Bevorzugt wird dabei pro Mol Sauerstoff in der Chromverbindung zwischen 0,75 und 1,25 Mol, vorzugsweise zwischen 0,90 und 1,05 Mol an Kohlenstoff eingesetzt. Dabei ist die Menge an für die Reaktion mit der Chromverbindung verfügbaren Kohlenstoff gemeint. In einer besonders bevorzugten Ausführungsvariante ist das Verhältnis O zu C mit etwa 0,98 leicht unterstöchiometrisch. Bevorzugt ist vorgesehen, dass die feste Kohlenstoffquelle ausgewählt ist aus der Gruppe Ruß, Aktivkohle, Graphit, kohlenstofffreisetzende Verbindungen oder Mischungen daraus. Als Beispiel für eine kohlenstofffreisetzende Verbindung können Chromkarbide, wie zum Beispiel Cr₃C₂, Cr₇C₃ oder Cr₂₃C₆ genannt werden. Die Pulvermischung wird in einer H₂-haltigen Atmosphäre auf T_{R} erhitzt. Der H₂-Druck wird dabei bevorzugt so eingestellt, dass sich zumindest im Temperaturbereich 800° bis 1050°C ein CH₄-Partialdruck von 5 bis 500 mbar ergibt. Die isotherme Phase auf T_{R} und Abkühlen auf Raumtemperatur erfolgen wiederum vorteilhaft in einer Wasserstoffatmosphäre. Während dieser Prozessphasen ist die Anwesenheit von Kohlenwasserstoff nicht erforderlich. Wasserstoff verhindert während dieser Prozessphase und während der Abkühlphase Rückoxidationsprozesse. Während der Abkühlphase wird bevorzugt eine Wasserstoffatmosphäre mit einem Taupunkt < -40°C eingesetzt.

Vor der Reduktion kann das Cr-Oxid- oder Cr-Hydroxidpulver granuliert werden. Als Granulieren bezeichnet man wie bereits erwähnt das Verwandeln von kleinen Partikeln in ein Granulat, das ein Haufwerk der kleinen Partikel darstellt. Als Granulierverfahren eignen sich beispielsweise Sprühgranulation oder Aufbaugranulationsverfahren in einem Intensivmischer unter Beigabe eines grenzflächenaktiven Zusatzes, beispielsweise Polyvinylpyrrolidon. Vorteilhaft ist ein Granulieren vor der Reduktion auch deshalb, da dadurch die Penetration der gasförmigen Edukte (zum Beispiel Wasserstoff) und der gasförmigen Produkte (zum Beispiel CO) verbessert wird, da zwischen den Granulatpartikeln Bereiche bestehen, wo die Gase ohne hohe Reibungsverluste durchströmen können.

Dem Cr-Oxid oder Cr-Hydroxid kann in vorteilhafter Weise vor der Reduktion, und insbesondere vorteilhaft, vor einem etwaigen Granulieren, ein oder mehrere Legierungselemente in oxidierter Form zugemischt werden. Bevorzugt lassen sich dabei die Oxide der Legierungselemente unter den Bedingungen der Reduktion des Chromoxids nicht oder nur geringfügig reduzieren, sodass gewährleistet ist, dass eine Mischkristallverfestigung des Chroms durch die Eindiffusion des Legierungselements im elementaren Zustand vermieden wird.

Im Folgenden wird die Erfindung anhand von Beispielen näher erläutert.
Figur 1 zeigt eine rasterelektronenmikroskopische Aufnahme des erfindungsgemäßen Beschichtungsstoffs mit einer Siebfraktion < 45 µm gemäß Beispiel 1.
Figur 2 zeigt eine rasterelektronenmikroskopische Aufnahme des erfindungsgemäßen Beschichtungsstoffs mit einer Siebfraktion 45 - 100 µm gemäß Beispiel 1.
Figur 3 zeigt ein elektrolytisch reduziertes Cr-Pulver mit einer Siebfraktion < 45 µm gemäß dem Stand der Technik.
Figur 4 zeigt eine erfindungsgemäße CGS Cr-Schicht, abgeschieden auf einem Stahlrohr unter Verwendung des erfindungsgemäßen Beschichtungsstoffs gemäß Beispiel 2.
Figur 5 zeigt eine rasterelektronenmikroskopische Aufnahme einer erfindungsgemäßen CGS Cr-Schicht abgeschieden auf einem AlMg3-Rohr unter Verwendung des erfindungsgemäßen Beschichtungsstoffs gemäß Beispiel 2.
Figur 6 zeigt eine rasterelektronenmikroskopische Aufnahme einer erfindungsgemäßen CGS Cr-Schicht unter Verwendung des erfindungsgemäßen Beschichtungsstoffs (gespritzt mit Anlage von Typ B) gemäß Beispiel 4.
Figur 7 zeigt eine rasterelektronenmikroskopische Aufnahme eines Stahlsubstrats, auf dem gemäß Beispiel 6 versucht wurde, eine CGS Cr-Schicht mit Stand der Technik Pulver abzuscheiden.
Figur 8 zeigt eine rasterelektronenmikroskopische Aufnahme einer erfindungsgemäßen CGS Cr-Schicht, abgeschieden auf einem Stahlsubstrat unter Verwendung des erfindungsgemäßen Beschichtungsstoffs gemäß Beispiel 6.
Figur 9 zeigt eine rasterelektronenmikroskopische Aufnahme einer erfindungsgemäßen CGS Cr-10Ma%Cr₂₃C₆ Schicht, hergestellt unter Verwendung des erfindungsgemäßen Beschichtungsstoffs, abgeschieden auf einem AIMg3 Substrat gemäß Beispiel 7.
Figur 10 zeigt rasterelektronenmikroskopische Aufnahme einer erfindungsgemäßen CGS Cr-50Ma%Cr₂₃C₆ Schicht, hergestellt unter Verwendung des erfindungsgemäßen Beschichtungsstoffs, abgeschieden auf einem AIMg3 Substrat gemäß Beispiel 7.
Figur 11 zeigt eine rasterelektronenmikroskopische Aufnahme einer erfindungsgemäßen CGS Cr-30 Ma%Cu Schicht, hergestellt unter Verwendung des erfindungsgemäßen Beschichtungsstoffs, abgeschieden auf einem AIMg3 Substrat gemäß Beispiel 8.
Figur 12 zeigt eine rasterelektronenmikroskopische Aufnahme einer APS Cr-Spritzschicht, hergestellt unter Verwendung des erfindungsgemäßen Beschichtungsstoffs gemäß Beispiel 9.
Figur 13 zeigt eine rasterelektronenmikroskopische Aufnahme einer erfindungsgemäßen CGS Cr-Y₂O₃ Schicht, hergestellt unter Verwendung des erfindungsgemäßen Beschichtungsstoffs, abgeschieden auf einem AIMg3 Substrat gemäß Beispiel 14.

### Beispiel 1

Eine Mischung aus Cr₂O₃ mit einer mittleren, mittels Laserbeugung gemessenen Teilchengröße d₅₀ von 0,9 µm und amorphem Ruß (Kohlenstoffgehalt 0,99 Mol/ Mol O in Cr₂O₃) wurde unter Einwirkung von H₂ auf 1050°C erhitzt.

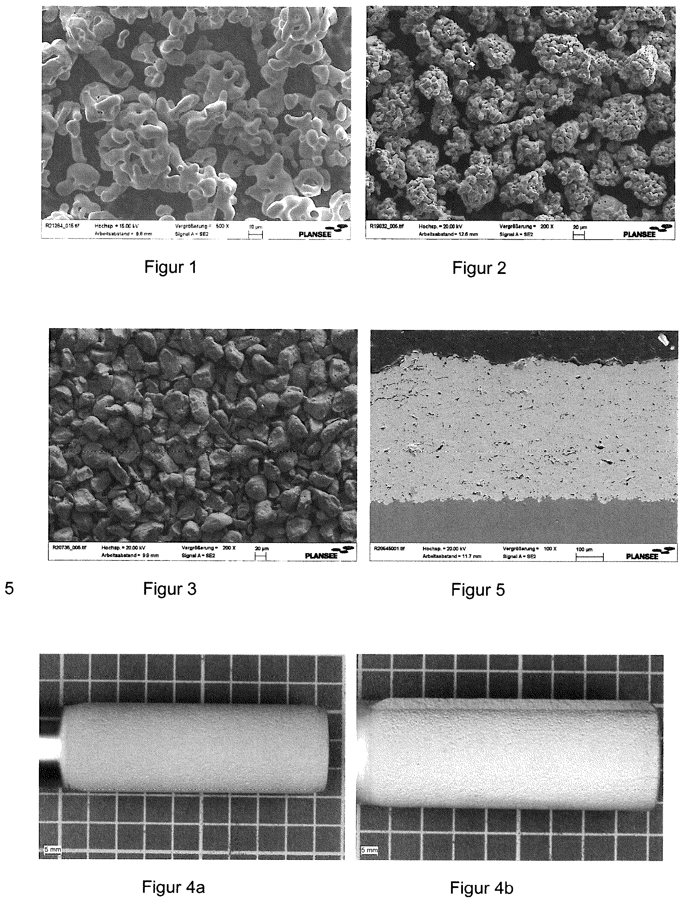

Die Aufheizgeschwindigkeit wurde so eingestellt, dass der massenspektrometrisch gemessene CH₄-Partialdruck im Temperaturbereich 800°C bis 1050°C > 15 mbar betrug. Danach wurde die Reaktionsmischung auf 1450°C erhitzt. Die Haltezeit bei 1450°C betrug 5 h. Das Aufheizen von 1050°C auf 1450°C und das Halten auf 1250°C erfolgten unter Zufuhr von trockenem Wasserstoff mit einem Taupunkt < -40°C, wobei der Druck ca. 1 bar betrug. Die Ofenabkühlung erfolgte ebenfalls unter H₂ mit einem Taupunkt < -40°C. Das so hergestellte Cr-Pulver wurde bei 45 µm (Siebfraktion < 45 µm) und der Rest bei 100 µm (Siebfraktion 45 - 100 µm) abgesiebt. Die Siebfraktion < 45 µm ist in den Figuren 1 und die Siebfraktion 45 - 100 µm in Figur 2 wiedergeben. Ein elektrolytisch reduziertes Cr-Pulver (siehe Figur 3) gemäß dem Stand der Technik wurde ebenfalls bei 45 µm abgesiebt. Dieses diente für Vergleichsversuche. Figur 1 und Figur 2 zeigen in eindeutiger Weise, dass die Partikel Poren aufweisen. Figur 1 und Figur 2 zeigen auch, dass die Partikel das typische Erscheinungsbild von Aggregaten oder Agglomeraten aufweisen. Es wurde versucht, das Pulver durch Einwirkung von Ultraschall (20 Hz, 600 W) zu deagglomerieren. Da dies jedoch nicht möglich war, liegt das Pulver gemäß der in der Beschreibung angeführten Definition als Aggregat vor. Das in Figur 3 abgebildete Stand der Technik Pulver weist weder Poren auf, noch liegt es als Agglomerat oder Aggregat vor.

Die Bestimmung der Porosität wurde wie in der Beschreibung detailliert ausgeführt durch quantitative Bildanalyse durchgeführt. Es wurde dabei die Porosität von 10 Partikeln bestimmt, wobei die Porositätswerte für die Siebfraktion 45 - 100 µm zwischen 65 Vol% und 74 Vol% lagen. Die mittlere Porosität betrug 69 Vol%. Für die Siebfraktion < 45 µm betrug die Porosität zwischen 25 Vol% und 73 Vol%. Die mittlere Porosität betrug 37 Vol%. Die BET-Oberfläche wurde nach

ISO 9277:1995 (Gerät: Gemini 2317 / Typ2, Entgasung bei 130°C / 2h in Vakuum, Adsorptiv: Stickstoff, volumetrische Auswertung über Fünfpunktbestimmung) bestimmt und betrug für die Siebfraktion 45 - 100 µm 0,09 m²/g und für die Siebfraktion < 45 µm 0,10 m²/g. Die Partikelgrößen wurden durch Laserdiffraktometrie (gemäß ISO13320 (2009)) bestimmt. Die d₅₀ Werte sind in Tabelle 1 wiedergegeben.

In weiterer Folge wurde ein Pulverschliff angefertigt und im Querschliff an Cr-reichen Bereichen die mittlere (Mittelwert aus 10 Messungen)

Nanohärte H_{IT} 0,005/5/1/5 (gemessen nach EN ISO 14577-1, Ausgabestand 2002, Berkovich-Eindringkörper und Auswerteverfahren nach Oliver und Pharr) bestimmt. Die mittleren Nanohärten sind ebenfalls in Tabelle 1 zusammengefasst. Die Röntgenbeugungsanalyse lieferte für alle Pulver nur Peaks für kubisch raumzentriertes (bcc) Chrommetall. Die chemischen Analysenwerte für C und O sind ebenfalls der Tabelle 1 zu entnehmen.

**Tabelle 1**

| | Cr-Pulver erfindungsgemäß Siebfraktion < 45 µm | Cr-Pulver erfindungsgemäß Siebfraktion 45-100 µm | Cr-Pulver Stand der Technik Siebfraktion < 45 µm |
|---|---|---|---|
| d₅₀ Partikelgröße (µm) | 26,9 | 74,5 | 35,4 |
| Nanohärte H_{IT} 0,005/5/1/5 (GPa) | 2,924 +/-0,105 | 2,758 +/- 0,074 | 5,321 +/- 0,328 |
| C-Gehalt [µg/g] | 114 | 123 | 87 |
| O-Gehalt [µg/g] | 1064 | 971 | 736 |

### Beispiel 2

Cr-Pulver mit der Partikelgrößenfraktion < 45 µm gemäß Beispiel 1 wurde durch Kaltgasspritzen (CGS) verspritzt. Die Substrate bestanden aus geschliffenen Rohren der Werkstoffe 1.4521 (X 2 CrMoTi 18-2) und AIMg3, wobei der Durchmesser 30 mm und die Länge 165 mm betrugen. Die Rohre wurden vor dem Beschichten mit Alkohol gereinigt, einseitig in eine rotationsfähige Aufnahme gespannt und am freien Ende beschichtet. Es wurde eine umfangseitige Schicht bei rotierendem Substrat sowie Zeilen in axialer Richtung ohne Substratrotation hergestellt. Der Kaltgasspritzprozess wurde mit Stickstoff (75,5 m³/h) durchgeführt. Der Prozessgasdruck betrug 34 bar und die Prozessgastemperatur 800°C. Das Prozessgas wurde dabei mit einem Heizer auf 500°C vorgewärmt und in einer Vorheizkammer in der Spritzpistole, in der auch die Zuführung des Pulvers erfolgte, auf die Prozessgastemperatur gebracht.

Das Prozessgas / Pulver - Gemisch wurde durch eine Laval - Düse (Ausführungsform einer Konvergent-Divergent Düse) geführt und mit einem Spritzabstand von 30 mm senkrecht zur Substratoberfläche verspritzt. Der axiale Vorschub der Spritzpistole betrug 5 mm/s und die Drehzahl 560 U/min. Die Pulverförderung erfolgte mit einer Lochscheibe aus einem Pulverbehälter, der unter einem Druck von 35 bar stand. Die Pulverfördermenge betrug ca. 100 g/min.

Es konnten Cr-Schichten mit dem typischen Erscheinungsbild (siehe Figur 4) von CGS-Schichten hergestellt werden. Bei rotierendem Substrat konnte eine Schichtdicke von 50 µm pro Durchgang erzielt werden. Es zeigt sich eine gute Verbindung der Schicht mit den Substratmaterialien. Die Schichtdichte (relative spezifische Dichte) wurde optisch mit Bildanalyse sowie mit dem Auftriebsverfahren bestimmt. Mit Bildanalyse wurde im Falle des AlMg3-Substrats eine mittlere Dichte von 91 % ermittelt, mit der Auftriebsdichtebestimmung 93,5 %. Der Querschliff dieser Schicht ist in Figur 5 wiedergegeben. Die dunklen Bereiche sind dabei präparationsbedingte Ausbrüche. In der Zeile wurde eine mittlere Dichte von 97,2 % (Auftriebsmethode) ermittelt. Die mittlere Nanohärte H_{IT} 0,005/5/1/5 betrug 6 GPa (Mittelwert aus 10 Einzelmessungen). Die Körner waren kaltverformt (Nachweis durch TEM Untersuchung) und wiesen zumindest teilweise ein Streckungsverhältnis (im Querschliff ermittelt, Bestimmung des Streckungsverhältnisses (Kornlänge / Kornbreite) durch quantitative Bildanalyse) von bis zu 5 auf.

### Beispiel 3

Unter den Bedingungen von Beispiel 2 (Abscheidung in Zeilen in axialer Richtung ohne Substratrotation) wurde die Prozessgastemperatur variiert. Folgende Prozessgastemperaturen kamen dabei zum Einsatz: 800°C, 700°C, 600°C, 500°C und 400°C. Bei allen Temperaturen konnten gut haftende Schichten abgeschieden werden. Die Schichtporosität ist bei den Prozessgastemperaturen von 800°C bis 600°C sehr gering. Bei Prozessgastemperaturen von 400°C und 500°C werden zeilenförmige Muster beobachtet, die auf eine etwas schwächere Bindung zwischen den einzelnen Schichtlagen hinweisen. In der Zeile wurde für die Prozessgastemperatur 800°C eine mittlere Dichte von 98,7 % (Auftriebsmethode) ermittelt. Die mittlere Nanohärte H_{IT} 0,005/5/1/5 betrug für die Prozessgastemperatur 800°C 6,3 GPa (Mittelwert aus 10 Einzelmessungen). Die Körner waren kaltverformt und wiesen zumindest teilweise ein Streckungsverhältnis von bis zu 6 (exemplarisch für Prozessgastemperatur 800°C ermittelt) auf.

### Beispiel 4

Erfindungsgemäßes Cr Pulver gemäß Beispiel 1 mit der Partikelgrößenfraktion < 45 µm wurde auf ein geschliffenes, mit Alkohol gereinigtes AIMg3 Rohr mit einem Durchmesser von 45 mm und einer Länge von 165 mm verspritzt. Der Kaltgasspritzprozess wurde mit Stickstoff mit einem Prozessgasdruck von 34 bar und einer Prozessgastemperatur von 800°C (Anlage des Typs A) und mit Stickstoff mit einem Prozessgasdruck von 41,6 bar und einer Prozessgastemperatur von 950°C (Anlage des Typs B) durchgeführt. Das Prozessgas wurde beim Typ A mit einem Heizer auf 500°C vorgewärmt und in einer Vorheizkammer in der Spritzpistole auf die Prozessgastemperatur gebracht. Beim Typ B erfolgte die Beheizung vollständig im Heizer der Spritzpistole, in der auch die Zuführung des Pulvers in einen Stickstoffstrom erfolgte. Das Prozessgas / Pulver - Gemisch wurde durch eine Laval - Düse geführt und mit einem Spritzabstand von 30 mm senkrecht zur Substratoberfläche verspritzt. Der axiale Vorschub der Spritzpistole betrug 5 mm/sec, die Drehzahl 560 U/min. Die Pulverförderung erfolgte gemäß Beispiel 2.

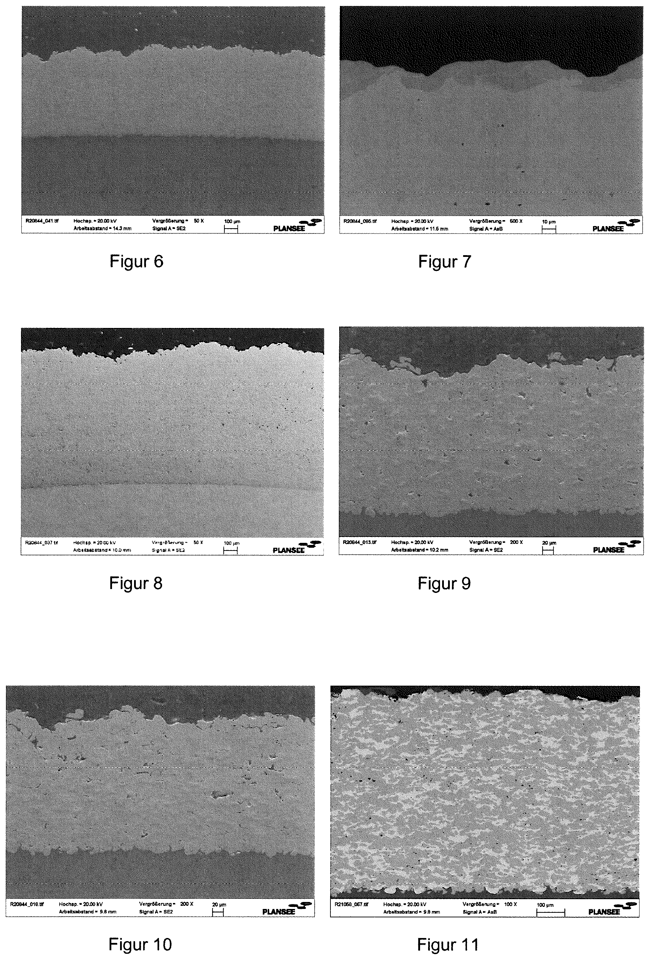

Mit den Prozessparametern des Anlagen-Typs A konnte mit 10 Durchläufen eine Schicht mit 330 µm hergestellt werden. Mit den Prozessparametern des Anlagen-Typs B konnte ebenfalls mit 10 Durchläufen eine Schicht mit 740 µm (siehe Figur 6) hergestellt werden. Die Verbindung beider Schichten mit dem Substratmaterial ist sehr gut.

Die Schicht (gespritzt mit Anlage B) wies eine mittlere Dichte von 99,2 % (Auftriebsmethode) auf. Die Körner waren kaltverformt und wiesen zumindest teilweise ein Streckungsverhältnis von bis zu 5,5 (exemplarisch für Anlage B ermittelt) auf.

### Beispiel 5

Ein erfindungsgemäßes Pulver gemäß Beispiel 1 mit der Partikelgrößenfraktion 45 - 100 µm wurde gemäß Beispiel 2 (Abscheidung in Zeilen in axialer Richtung ohne Substratrotation) verspritzt. Die Prozessgastemperaturen betrugen dabei 800°C, 700°C, 600°C, 500°C und 400°C. Bei allen Temperaturen konnten gut haftende Schichten abgeschieden werden. Bei Prozessgastemperaturen von 800°C, 700°C und 600°C konnten dichte und fehlerfreie Schichten erzeugt werden. Bei 500°C und 400°C zeigt sich eine zeilige Struktur, die auf eine etwas schlechte Bindung zwischen den einzelnen Schichtlagen hinweist. In der Zeile wurde für die Prozessgastemperatur 800°C eine mittlere Dichte von 98,5 % und für die Prozessgastemperatur 600°C eine mittlere Dichte von 97,5 % (jeweils mit Auftriebsmethode gemessen) ermittelt. Die Körner waren kaltverformt und wiesen zumindest teilweise ein Streckungsverhältnis von bis zu 5,5 (Prozessgastemperatur 600°C) bzw. von bis zu 6 (Prozessgastemperatur 800°C) auf. Die mittlere Nanohärte H_{IT} 0,005/5/1/5 betrug für die Prozessgastemperatur 600°C 6,7 GPa (Mittelwert aus 10 Einzelmessungen).

### Beispiel 6

Erfindungsgemäßes Pulver gemäß Beispiel 1 sowie ein Pulver nach dem Stand der Technik (elektrolytisch reduziert, siehe Figur 3) jeweils mit einer Partikelgrößenfraktion < 45 µm wurden mit einer Kaltgas-Spritzanlage vom Typ B (siehe Beispiel 4) auf ein geschliffenes, mit Alkohol gereinigtes Stahlrohr mit einem Durchmesser von 60 mm und einer Länge von 165 mm verspritzt. Der Kaltgasspritzprozess wurde bei einem Prozessgasdruck von 41,6 bar und einer Prozessgastemperatur von 950°C durchgeführt. Das Prozessgas/Pulver-Gemisch wurde durch eine Laval-Düse geführt und mit einem Spritzabstand von 30 mm senkrecht zur Substratoberfläche verspritzt. Der axiale Vorschub der Spritzpistole betrug 5 mm/sec, die Drehzahl 560 U/min. Die Pulverförderung erfolgte gemäß Beispiel 2. Während mit dem Stand der Technik Pulver keine Schicht (nur fragmentierte Cr-Bereiche, siehe Figur 7) hergestellt werden konnte, wurde mit dem erfindungsgemäßen Pulver eine Schichtdicke von 1190 µm (siehe Figur 8) erreicht.

### Beispiel 7

1617 g Cr₂O₃ (Pigmentqualität Lanxess Bayoxide CGN-R) wurde mit 382,8 g Ruß in einem Diffusionsmischer vermischt. Die so hergestellte Mischung wurde mit einer Aufheizgeschwindigkeit von 10 K/min auf 800°C und danach mit einer Aufheizgeschwindigkeit von 2 K/min auf 1050°C erhitzt. Das Aufheizen erfolgte unter Einwirkung von H₂, wobei der H₂-Druck so eingestellt wurde, dass im Temperaturbereich 800°C bis 1050°C der massenspektrometrisch gemessene CH₄-Partialdruck > 15 mbar betrug. Der Gesamtdruck betrug dabei ca. 1 bar. Danach wurde die Reaktionsmischung mit einer Aufheizgeschwindigkeit von 10 K/min auf 1450°C erhitzt. Die Haltezeit auf 1450°C betrug 7 h. Aufheizen von 1050°C auf 1450°C und Halten auf 1450°C erfolgten unter Zufuhr von trockenem Wasserstoff mit einem Taupunkt < -40°C, wobei der Druck ca. 1 bar betrug.

Die Ofenabkühlung erfolgte ebenfalls unter H₂ mit einem Taupunkt < -40°C. Die Cr-enthaltenden Partikel des so erhaltenen Pulvers lagen zu einem Anteil von > ca. 50 Ma% als Aggregat und ca. 10 Ma% als Agglomerat vor. Der verbleibende Anteil wies gemäß der ASM Einteilung eine ungleichmäßige Form auf. Zudem wiesen die Cr-enthaltenden Partikel zumindest teilweise Poren auf. Eine chemische Analyse des Pulvers ergab einen C-Gehalt von 5720 µg/g und einen O-Gehalt von 420 µg/g. Eine XRD Analyse des Pulvers ergab nur Peaks für die Phasen Cr (bcc) und Cr₂₃C₆. Basierend auf den C-Gehalt ergibt sich eine Zusammensetzung von 90 Ma% Cr und 10 Ma% Cr₂₃C₆. Die BET-Oberfläche des Pulvers betrug 0,09 m²/g und die mittels Laserdiffraktometrie bestimmte Partikelgröße d₅₀ betrug 32,2 µm. Dieses Pulver wurde unter den Bedingungen von Beispiel 2 verspritzt. Es konnte eine dichte, gut haftende Schichten mit einer Schichtdicke von 250 µm abgeschieden werden. In analoger Weise wurde auch eine Schicht mit der Zusammensetzung 50 Ma% Cr und 50 Ma% Cr₂₃C₆ hergestellt. Beispielhaft (Substrat jeweils AIMg3 Rohr) sind diese Schichten in Figur 9 und Figur 10 wiedergeben.

Für 90 Ma% Cr - 10 Ma% Cr₂₃C₆ wurde eine mittlere Dichte von 99,0 % und für 50 Ma% Cr - 50 Ma% Cr₂₃C₆ eine mittlere Dichte von 98,2 % (jeweils mit Auftriebsmethode gemessen) ermittelt. Die Cr-haltigen Körner waren kaltverformt und wiesen zumindest teilweise ein Streckungsverhältnis von bis zu 5 (90 Ma% Cr - 10 Ma% Cr₂₃C₆) bzw. von bis zu 7 (50 Ma% Cr - 50 Ma% Cr₂₃C₆) auf. Die mittlere Nanohärte H_{IT} 0,005/5/1/5 der Cr-haltigen Körner betrug für 50 Ma% Cr - 50 Ma% Cr₂₃C₆ 7,2 GPa (Mittelwert aus 10 Einzelmessungen).

### Beispiel 8

Erfindungsgemäßes Pulver gemäß Beispiel 1 mit einer Partikelgrößenfraktion < 45 µm wurde mit 1 Ma%, 5 Ma%, 10 Ma%, 20 Ma% und 30 Ma% verdüstem Cu-Pulver mit einer laseroptisch gemessenen Partikelgröße d₅₀ 26 µm gemischt und unter Verwendung von zwei Pulverfördereinheiten verspritzt. Substratwerkstoffe und Anordnung entsprechen dem Beispiel 2. Der Kaltgasspritzprozess wurde mit Stickstoff (75,5 m³/h) bei 41,6 bar und 950°C (Anlage TYP B) sowie 34 bar und 800°C (Anlage TYP A) durchgeführt. Es konnten mit allen Pulvermischungen / Anlagen fehlerfreie und gut haftende Schichten mit einer Dicke von ca. 400 - 800 µm hergestellt werden. Beispielhaft ist die Schichtstruktur für die Zusammensetzung Cr- 30 Ma%Cu / Anlage Typ B in Figur 11 wiedergegeben.

Für 30 Ma% Cu wurde eine mittlere Dichte von 99,6 % (Auftriebsmethode) ermittelt. Die Cr-haltigen Körner waren kaltverformt und wiesen zumindest teilweise ein Streckungsverhältnis von bis zu 10 (30 Ma% Cu) auf. Die mittlere Nanohärte H_{IT} 0,005/5/1/5 der Cr-haltigen Körner betrug für 30 Ma% Cu 5,2 GPa (Mittelwert aus 10 Einzelmessungen).

### Beispiel 9

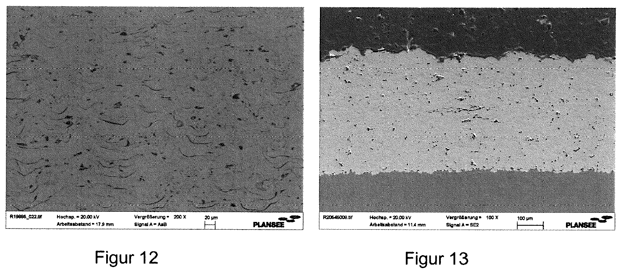

Erfindungsgemäßes Cr Pulver gemäß Beispiel 1 mit einer Partikelgrößenfraktion von 45 - 100 µm wurde mittels HVOF und APS unter üblichen Bedingungen verspritzt. Es konnten dichte, gut haftende Schichten herstellt werden. Beispielhaft ist eine APS Schicht in Figur 12 wiedergegeben.

### Beispiel 10

Erfindungsgemäßes Cr Pulver gemäß Beispiel 1 mit einer Partikelgrößenfraktion von 45 - 100 µm wurde galvanisch in einem Wattsbad, das mit einer rotierenden Elektrode gerührt wurde, vernickelt. Die Dicke der Nickelschicht betrug 4 µm. Das Pulver wurde auf ein geschliffenes, gereinigtes X 2 CrMoTi 18-2 Rohr mit einem Durchmesser 30 mm unter den Bedingungen gemäß Beispiel 2 gespritzt. Es konnten gut haftende Cr-Ni Schichten mit einer Dicke von 250 µm hergestellt werden. Mit Auftriebsmethode wurde eine mittlere Dichte von 98 % ermittelt.

### Beispiel 11

Es wurde ein MCrAIY Pulver mit der Zusammensetzung 25 Ma% Cr, 10 Ma% Al 0,5 Ma% Y, Rest Ni hergestellt. Dazu wurde Cr Pulver gemäß Beispiel 1 mit einer Partikelgrößenfraktion von 45 - 100 µm mit Ni Pulver der Kornfraktion 20 - 45 µm, Y₂O₃ Pulver (d₅₀= 0,6 µm) und mit Al Pulver (d₅₀= 10,6 µm) vermischt. Das Pulver wurde auf ein geschliffenes, gereinigtes X 2 CrMoTi 18-2 Rohr mit einem Durchmesser 30 mm unter den Bedingungen gemäß Beispiel 2 gespritzt. Es konnte wiederum eine gut haftende Schicht hergestellt werden. Mit Auftriebsmethode wurde eine mittlere Dichte von 98,5 % ermittelt.

### Beispiel 12

Erfindungsgemäßes Pulver gemäß Beispiel 1 mit einer Partikelgrößenfraktion < 45 µm wurde mit 1 Ma%, 3 Ma% und 5 Ma% MoS₂ Pulver mit einer Partikelgröße nach Fisher von ca. 1 µm gemischt und verspritzt. Substratwerkstoffe und Anordnung entsprechen dem Beispiel 2. Der Kaltgasspritzprozess wurde mit Stickstoff (75,5 m³/h) bei 41,6 bar und 950°C (Anlage Typ B) durchgeführt. Es konnten mit allen Pulvermischungen fehlerfreie und gut haftende Schichten mit einer Dicke von ca. 300 µm hergestellt werden.

### Beispiel 13

Erfindungsgemäßes Pulver gemäß Beispiel 1 mit einer Partikelgrößenfraktion < 45 µm wurde mit 3 Ma% Graphitpulver mit einer Partikelgröße nach Fisher von ca. 0,5 µm gemischt. Das Graphitpulver wurde dabei in die Poren des Chrompulvers geschmiert, wodurch die Poren zum Teil gefüllt wurden. Das Pulver wurde gemäß Beispiel 2 verspritzt. Es konnten wiederum fehlerfreie und gut haftende Schichten mit einer Dicke von ca. 500 µm hergestellt werden.

### Beispiel 14

1627,2 g Cr₂O₃-Pulver (Pigmentqualität Lanxess Bayoxide CGN-R), 372,8 g Ruß (Thermax Ultra Pure N 908 der Firma Cancarb), 1,2 g Y₂O₃ mit einer mittels Laserdiffraktometrie gemessenen Partikelgröße d₅₀ von 0,9 µm wurden in einem Attritor unter Zugabe von 1,5 I Isopropanol 3 Stunden gemahlen. Die Mahlkugeln waren dabei aus stabilisiertem Y₂O₃. Das Kugel zu Pulver Verhältnis betrug 6 : 1. Der so hergestellte Slurry wurde in Vakuum getrocknet und mit einer Aufheizgeschwindigkeit von 10 K/min auf 800°C und danach mit einer Aufheizgeschwindigkeit von 2 K/min auf 1050°C erhitzt. Das Aufheizen erfolgte unter Einwirkung von H₂, wobei der H₂-Druck so eingestellt wurde, dass im Temperaturbereich 800°C bis 1050°C der massenspektrometrisch gemessene CH₄-Partialdruck > 15 mbar betrug. Der Gesamtdruck betrug dabei ca. 1 bar. Danach wurde die Reaktionsmischung mit einer Aufheizgeschwindigkeit von 10 K/min auf 1450°C erhitzt. Die Haltezeit auf 1450°C betrug 4,5 h. Aufheizen von 1050°C auf 1450°C und Halten auf 1450°C erfolgten unter Zufuhr von trockenem Wasserstoff mit einem Taupunkt < -40°C, wobei der Druck ca. 1 bar betrug. Die Ofenabkühlung erfolgte ebenfalls unter H₂ mit einem Taupunkt < -40°C. Danach wurde der Sinterkuchen zu einem Pulver gebrochen. Das so hergestellte Pulver wies eine aggregierte und poröse Struktur auf. Auf der Oberfläche der Cr-haltigen porösen Partikel konnten feine Y₂O₃ Teilchen mit einem mittleren Teilchendurchmesser < 1 µm nachgewiesen werden. Die chemische Analyse ergab 291 µg/g C, 1320 µg/g O und 1128 µg/g Y, Rest Cr und übliche Verunreinigungen. Die Porosität der mit Y₂O₃ dotierten Variante wurde, wie in der Beschreibung detailliert ausgeführt, mittels quantitativer Bildanalyse durchgeführt, wobei als Messrahmen Kreise und Rechtecke verwendet wurden. Es wurde die Porosität von 10 Partikeln bestimmt, wobei die Werte zwischen 61 Vol% und 75 Vol% lagen. Die mittlere Porosität betrug 67,1 Vol%. Durch Absieben wurden Korngrößenfraktionen von < 32 µm und 23 - 45 µm hergestellt und mit einer Anlage vom Typ A gemäß Beispiel 2 verspritzt. Es konnten wiederum dichte, gut haftende Schichten mit einer Dicke von ca. 400 µm (siehe Figur 13) hergestellt werden.

## Patentansprüche

1. Verfahren zur Herstellung einer Schicht durch Kaltgasspritzen unter Verwendung eines Beschichtungsstoffs, der Cr- enthaltende Partikel mit einem Cr-Gehalt > 95 Ma% und gelöste Elemente mit einem Anteil von ≤ 5 Ma% umfasst,
wobei der Cr-Gehalt im Beschichtungsstoff > 20 Ma% ist,
wobei die Cr-enthaltenden Partikel zumindest teilweise Poren aufweisen,
wobei die Cr-enthaltenden Partikel zumindest teilweise eine mittlere, mittels quantitativer Bildanalyse bestimmte Porosität von > 10 Vol% aufweisen, und
wobei die Cr-enthaltenden Partikel eine mittels BET gemäß ISO 9277:1995 gemessene mittlere Oberfläche > 0,05 m²/g aufweisen.

2. Verfahren nach Anspruch 1, **dadurch gekennzeichnet, dass** dieses zumindest folgende Schritte umfasst:
a. Bereitstellen eines Prozessgases mit einem Druck von 10 bis 100 bar und einer Temperatur zwischen Raumtemperatur und 1400°C;
b. Beschleunigung des Prozessgases in einer Konvergent-Divergent Düse
c. Injizieren des Beschichtungsstoffs vor, in oder nach der Konvergent-Divergent Düse in das Prozessgas;
d. Bildung einer haftenden Schicht beim Auftreffen des Beschichtungsstoffs auf einem Substrat.

3. Verfahren nach Anspruch 2, **dadurch gekennzeichnet, dass** das Prozessgas Stickstoff oder ein Stickstoff reiches Gas ist.

4. Schicht mit einem Cr-Gehalt > 50 Ma%, einer mittleren Dicke > 20 µm und einem Mikrogefüge, das zumindest teilweise verformte Cr-haltige Körner aufweist, erhältlich durch ein Verfahren nach einem der Ansprüche 1 bis 3.

5. Schicht nach Anspruch 4, **dadurch gekennzeichnet, dass** die verformten Cr-haltigen Körner kaltverformt sind.

6. Schicht nach Anspruch 4 oder 5, **dadurch gekennzeichnet, dass** die Körner zumindest teilweise in einer Richtung parallel zur Schichtoberfläche gestreckt sind.

7. Schicht nach Anspruch 6, **dadurch gekennzeichnet, dass** die Körner ein mittleres Streckungsverhältnis > 1,3 aufweisen.

8. Schicht nach einem der Ansprüche 4 bis 7, **dadurch gekennzeichnet, dass** die verformten Cr-haltigen Körner eine mittlere Nanohärte H_{IT} 0,005/5/1/5 von > 4 GPa, bestimmt nach EN ISO 14577-1 (Ausgabe 2002), aufweisen.

## Claims

1. Process for the production of a coating by cold gas spraying using a coating material comprising Cr-containing particles having a Cr content > 95% by mass and of dissolved elements with a content of ≤ 5% by mass,
wherein the Cr content of the coating material is > 20% by mass,
wherein at least some of the Cr-containing particles have pores, wherein at least some of the Cr-containing particles have a mean porosity, determined by means of quantitative image analysis, of > 10% by volume, and wherein the Cr-containing particles have a mean surface area, measured by means of BET according to ISO 9277:1995, > 0.05 m²/g.

2. Process according to Claim 1, **characterized in that** it comprises at least the following steps:
a. providing a process gas having a pressure of from 10 to 100 bar and a temperature between room temperature and 1400°C;
b. accelerating the process gas in a convergent-divergent nozzle;
c. injecting the coating material into the process gas upstream, in or downstream of the convergent-divergent nozzle;
d. forming an adherent coating upon impact of the coating material on a substrate.

3. Process according to Claim 2, **characterized in that** the process gas is nitrogen or a nitrogen-rich gas.

4. Coating having a Cr content > 50% by mass, a mean thickness > 20 µm and a microstructure which contains at least partially deformed Cr-containing grains, obtainable by a process according to one of Claims 1 to 3.

5. Coating according to Claim 4, **characterized in that** the deformed Cr-containing grains are cold deformed.

6. Coating according to Claim 4 or 5, **characterized in that** at least some of the grains are stretched in a direction parallel to the layer surface.

7. Coating according to Claim 6, **characterized in that** the grains have a mean aspect ratio > 1.3.

8. Coating according to one of Claims 4 to 7, **characterized in that** the deformed Cr-containing grains have a mean nanohardness H_{IT} 0.005/5/1/5 of > 4 GPa, determined according to EN ISO 14577-1 (Edition 2002).

## Revendications

1. Procédé pour la fabrication d'une couche par projection par gaz froid à l'aide d'une substance de revêtement qui comprend des particules contenant du Cr, présentant une teneur en Cr > 95% en masse et des éléments dissous en une proportion ≤ 5% en masse, la teneur en Cr dans la substance de revêtement étant > 20% en masse, les particules contenant du Cr présentant au moins partiellement des pores, les particules contenant du Cr présentant au moins partiellement une porosité, déterminée par analyse quantitative d'image, > 10% en volume et les particules contenant du Cr présentant une surface moyenne, mesurée par BET selon la norme ISO 9277:1995, > 0,05 m²/g.

2. Procédé selon la revendication 1, **caractérisé en ce que** celui-ci comprend au moins les étapes suivantes :
a. mise à disposition d'un gaz de procédé présentant une pression de 10 à 100 bars et une température entre la température ambiante et 1400°C ;
b. accélération du gaz de procédé dans une buse convergente-divergente ;
c. injection de la substance de revêtement avant, dans ou après la buse convergente-divergente dans le gaz de procédé ;
d. formation d'une couche adhésive lors de l'impact de la substance de revêtement sur un substrat.

3. Procédé selon la revendication 2, **caractérisé en ce que** le gaz de procédé est l'azote ou un gaz riche en azote.

4. Couche présentant une teneur en Cr > 50% en masse, une épaisseur moyenne > 20 µm et une microstructure qui présente des grains au moins partiellement déformés, contenant du Cr, pouvant être obtenue par un procédé selon l'une quelconque des revendications 1 à 3.

5. Couche selon la revendication 4, **caractérisée en ce que** les grains déformés contenant du Cr sont déformés à froid.

6. Couche selon la revendication 4 ou 5, **caractérisée en ce que** les grains sont au moins partiellement allongés dans une direction parallèle à la surface de la couche.

7. Couche selon la revendication 6, **caractérisée en ce que** les grains présentent un rapport d'allongement moyen > 1,3.

8. Couche selon l'une quelconque des revendications 4 à 7, **caractérisée en ce que** les grains déformés contenant du Cr présentent une nanodureté moyenne H_{IT} 0,005/5/1/5 > 4 GPa, déterminée selon la norme EN ISO 14577-1 (édition 2002).
